# EUROPEAN PATENT SPECIFICATION

(11) **EP 4 136 753 B1**
(45) Date of publication and mention of the grant of the patent: **29.05.2024**
(21) Application number: 21723512.6
(22) Date of filing: 12.04.2021
(51) Int. Cl.: H03G 3/30, G10L 19/008, G10L 21/0324, H03G 7/00, H04H 60/04

(54) **AUTOMATED MIXING OF AUDIO DESCRIPTION**
AUTOMATISIERTE MISCHUNG VON AUDIOBESCHREIBUNGEN
MIXAGE AUTOMATISÉ DE DESCRIPTION AUDIO

(30) Priority: 13.04.2020 US 202063009327 P
(43) Date of publication of application: 22.02.2023
(73) Proprietor: Dolby Laboratories Licensing Corporation, San Francisco, CA 94103 (US)
(72) Inventor: VAN VEEN, Daniel, San Francisco, California 94103 (US); PANKEY, Satej, San Francisco, California 94103 (US)
(74) Representative: Dolby International AB Patent Group Europe
(86) International application number: PCT/US2021/026926
(87) International publication number: WO 2021/211471

(56) References cited:
- US-A1- 2010 211 199
- US-B1- 7 825 322
- "Digital Audio Compression (AC-4) Standard; Part 2: Immersive and personalized audio", ETSI TECHNICAL SPECIFICATION, EUROPEAN TELECOMMUNICATIONS STANDARDS INSTITUTE (ETSI), 650, ROUTE DES LUCIOLES ; F-06921 SOPHIA-ANTIPOLIS ; FRANCE , vol. BROADCAS, no. V1.2.1 6 February 2018 (2018-02-06), pages 1-250, XP014311251, Retrieved from the Internet: URL:http://www.etsi.org/deliver/etsi_ts/10 3100_103199/10319002/01.02.01_60/ts_103190 02v010201p.pdf [retrieved on 2018-02-06]
- Fabian Kuech ET AL: "Audio Engineering Society Convention Paper Dynamic Range and Loudness Control in MPEG-H 3D Audio", AES Convention 139, 29 October 2015 (2015-10-29), pages 1-10, XP055612916, New York, USA Retrieved from the Internet: URL:http://www.aes.org/tmpFiles/elib/20190 814/18021.pdf [retrieved on 2019-08-14]
- JEFFREY RIEDMILLER ET AL: "Immersive & Personalized Audio: A Practical System for Enabling Interchange, Distribution & Delivery of Next Generation Audio Experiences", ANNUAL TECHNICAL CONFERENCE & EXHIBITION, SMPTE 2014, vol. 124, no. 5, 26 October 2015 (2015-10-26), pages 1-23, XP055611936, Hollywood, CA, USA DOI: 10.5594/j18578 ISBN: 978-1-61482-954-6
- JEFFREY RIEDMILLER ET AL: "Delivering Scalable Audio Experiences using AC-4", IEEE TRANSACTIONS ON BROADCASTING., vol. 63, no. 1, 1 March 2017 (2017-03-01), pages 179-201, XP055611935, US ISSN: 0018-9316, DOI: 10.1109/TBC.2017.2659623

## Description

### FIELD

The present disclosure relates to audio processing, and in particular, to audio mixing.

### BACKGROUND

Audio description generally refers to a verbal description of the visual components of audio-visual media, such as a movie. The audio description helps visually impaired consumers to perceive the audio-visual media. For example, the audio description may verbally describe the visual aspects of a movie, such as the movements of characters and objects, facial expressions, etc. The audio description is differentiated from what is referred to as the main audio (also called the default audio), which refers to the audio aspects of the audio-visual content itself (e.g., dialogue, sound effects, background music, etc.).

In general, an audio description is generated as a separate file that an audio engineer mixes in with the main audio file, creating a version of the audio that now contains the audio description. The audio engineer performs the mixing in order to create a consistent listening experience, for example so that the audio description is audible during loud scenes, and that the audio description is not too loud during quiet scenes. Applying a gain that reduces the loudness level (e.g., a gain less than 1.0) may be referred to as ducking.

A content provider (e.g., the Netflix^{™} service, the Amazon Prime Video^{™} service, the Hulu^{™} service, the Apple TV+^{™} service, etc.) may then make available various audio file versions that a consumer may select. These versions may include the main audio file in various formats (stereo, 5.1-channel surround sound, etc.), in various languages (e.g., English, Spanish, French, Japanese, Korean, etc.), versions with audio description, etc. The content provider stores the audio file versions and provides the selected audio file to the consumer, for example as the audio component of an audio-visual data stream (e.g., via the hypertext transfer protocol (HTTP) live streaming (HLS) protocol).

As mentioned above, the audio file versions may have a number of formats, including monaural, stereo, 5.1-channel surround sound, 7.1-channel surround sound, etc. Other audio formats that are of more recent development include the Ambisonics format (also referred to as B-format), the Dolby Atmos^{™} format, etc. for surround sound. In general, the Ambisonics format corresponds to a three-dimensional representation of the sound pressure and sound pressure gradients in various dimensions. In general, the Dolby Atmos^{™} format corresponds to a collection of audio objects that each include an audio track and metadata defining where the audio track is to be output.

"Digital Audio Compression (AC-4) Standard" provides technical specification in immersive and personalized audio. The document is related to the audio compression standard which may be applied to a computer-implemented method of audio processing and a corresponding apparatus to execute a corresponding program.

"Audio Engineering society Convention Paper Dynamic Range and Loudness Control in MPEG-H 3D Audio" by Fabian K et al. is related to the MPEG-H 3D Audio standard. It is related to a detailed overview on the MPEG-H 3D Audio, which allows personalization and adaptation of the audio content to different use scenarios with highly efficient immersive audio transmission. It also provides an enhanced concept for loudness and dynamic range control (DRC) to adapt the characteristics of the audio content to the requirements of different playback scenarios and listening conditions.

" Immersive & Personalized Audio: A practical system for enabling Interchange, Distribution & Delivery of Next Generation Audio Experiences" by Jeffrey R et al. is related to several practical methods that enable accessible, immersive, and personalized experiences from production through playback across broadcast, cable, satellite, internet protocol television, and over-the-top platforms.

US 2010/211199 A1 and US 7 825 322 B1 then disclose methods for combining different audio object data.

### SUMMARY

One issue with existing systems is the time required to perform the mixing. The mixing generally requires the audio engineer to spend multiple person-hours per hour of content. For example, a 90-minute movie may involve 16-24 person-hours to generate the audio mix containing the audio description. Furthermore, there may be multiple base formats of the audio (e.g., stereo, 5. 1-channel surround sound) and multiple languages; generating the audio description mix for each combination of format and language multiplies the time required. Embodiments are directed to automatically generating the mix containing the audio description, in order to reduce the time required by the audio engineer.

According to an embodiment, a computer-implemented method of audio processing includes receiving audio object data and audio description data, where the audio object data includes a first set of audio objects. The method further includes calculating a long-term loudness of the audio object data and a long-term loudness of the audio description data. The method further includes calculating short-term loudnesses of the audio object data and short-term loudnesses of the audio description data. The method further includes reading a first set of mixing parameters that correspond to the audio object data. The method further includes generating a second set of mixing parameters based on the first set of mixing parameters, the long-term loudness of the audio object data, the long-term loudness of the audio description data, the short-term loudnesses of the audio object data, and the short-term loudnesses of the audio description data. The method further includes generating a gain adjustment visualization corresponding to the second set of mixing parameters, the audio object data and the audio description data. The method further includes generating mixed audio object data by mixing the audio object data and the audio description data according to the second set of mixing parameters. The mixed audio object data includes a second set of audio objects, and the second set of audio objects correspond to the first set of audio objects mixed with the audio description data according to the second set of mixing parameters.

According to another embodiment, an apparatus includes a processor and a display. The processor is configured to control the apparatus to implement one or more of the methods described herein. The display is configured to display the gain adjustment visualization. The apparatus may additionally include similar details to those of one or more of the methods described herein.

According to another embodiment, a non-transitory computer readable medium stores a computer program that, when executed by a processor, controls an apparatus to execute processing including one or more of the methods described herein.

The following detailed description and accompanying drawings provide a further understanding of the nature and advantages of various implementations.

### BRIEF DESCRIPTION OF THE DRAWINGS

FIG. 1 is a block diagram of an audio mixing system 100.
FIG. 2 is a block diagram of a loudness measurement component 200.
FIG. 3 is a block diagram showing additional components of the mixing component 116 (see FIG. 1).
FIG. 4 is a graph 400 showing a visualization 402 of the visualization data 142 (see FIG. 1).
FIG. 5 is a block diagram of an audio mixing system 500.
FIG. 6 is a device architecture 600 for implementing the features and processes described herein, according to an embodiment.
FIG. 7 is a flowchart of a method 700 of audio processing.

### DETAILED DESCRIPTION

Described herein are techniques related to audio processing. In the following description, for purposes of explanation, numerous examples and specific details are set forth in order to provide a thorough understanding of the present disclosure. It will be evident, however, to one skilled in the art that the present disclosure as defined by the claims may include some or all of the features in these examples alone or in combination with other features described below, and may further include modifications of the features and concepts described herein.

In the following description, various methods, processes and procedures are detailed. Although particular steps may be described in a certain order, such order is mainly for convenience and clarity. A particular step may be repeated more than once, may occur before or after other steps (even if those steps are otherwise described in another order), and may occur in parallel with other steps. A second step is required to follow a first step only when the first step must be completed before the second step is begun. Such a situation will be specifically pointed out when not clear from the context.

In this document, the terms "and", "or" and "and/or" are used. Such terms are to be read as having an inclusive meaning. For example, "A and B" may mean at least the following: "both A and B", "at least both A and B". As another example, "A or B" may mean at least the following: "at least A", "at least B", "both A and B", "at least both A and B". As another example, "A and/or B" may mean at least the following: "A and B", "A or B". When an exclusive-or is intended, such will be specifically noted (e.g., "either A or B", "at most one of A and B").

This document describes various processing functions that are associated with structures such as blocks, elements, components, circuits, etc. In general, these structures may be implemented by a processor that is controlled by one or more computer programs.

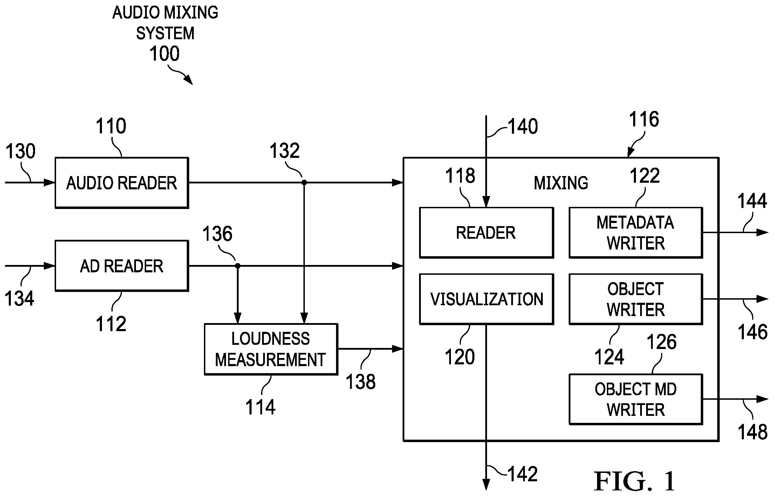

FIG. 1 is a block diagram of an audio mixing system 100. The audio mixing system 100 generally receives audio object data 102 and audio description data 104, performs mixing, and generates mixed audio object data 106. The audio mixing system 100 includes an audio object reader 110, an audio description (AD) reader 112, a loudness measurement component 114, a mixing component 116, a metadata reader 118, a visualization component 120, a metadata writer 122, an audio object writer 124, and an object metadata writer 126. The components of the audio mixing system 100 may be implemented by one or more computer programs that are executed by a processor of the audio mixing system 100. The audio mixing system 100 may include other components, such as a display for displaying a gain adjustment visualization, a speaker for outputting audio, etc. that the audio engineer may use when mixing audio with the audio mixing system 100; these components are not discussed in detail.

The audio object reader 110 reads an audio file 130 and generates audio object data 132. In general, the audio file 130 is one of a number of audio files and corresponds to a master version of the main audio for an audio-visual content file. A given audio-visual content file may have a number of audio files, each corresponding to a combination of an audio format (e.g., monaural, stereo, 5.1-channel surround sound, 7.1-channel surround sound, audio object file, etc.) and a dialogue language (e.g., English, Spanish, French, Japanese, Korean, etc.). The audio mixing system 100 is suitable for mixing audio object files, so the audio file 130 is an audio object file for a given dialogue language. For example, the audio engineer may select the English dialogue master object audio file for a given movie as the audio file 130.

The audio object data 132 corresponds to the audio objects in the audio file 130. In general, the audio object data 132 includes audio objects. An audio object generally corresponds to an audio file and location metadata. The location metadata instructs a rendering system how to render the audio file at a given location; this can include the size of the audio (pinpoint vs. diffuse), panning, etc. The rendering system then performs the rendering using the metadata to generate an appropriate output given the specific loudspeaker arrangement in the rendering environment. The maximum number of audio objects in the audio object data 132 may vary depending on the specific implementation. For example, audio object data in the Dolby Atmos^{™} format may have a maximum of 128 objects.

The audio object data 132 may also include audio beds, for example as a subtype of the audio objects or as separate bed objects. An audio bed generally corresponds to an audio file that is to be rendered at a defined bed location. Generally, each bed location corresponds to a channel that is output by an array of loudspeakers, and is useful for dialogue, ambience sounds, etc. Typical bed locations include a center channel, a low-frequency effects channel, etc. The bed locations may correspond to surround sound channels, such as 5.1-channel surround locations, 7.1-channel surround locations, 7.1.4-channel surround locations, etc.

The audio description reader 112 reads an audio description file 134 and generates audio description data 136. In general, the audio description file 134 is one of a number of audio description files stored by the audio mixing system 100, and the audio engineer selects the audio description file that is desired to be mixed with the audio-visual content corresponding to the audio object file 130. The audio description for a given audio-visual content may be in multiple formats, e.g. monaural, stereo, 5.1-channel surround sound, 7.1-channel surround sound, etc. As a result, there are many selectable combinations of the audio object file 130 and the audio description file 134 for a given audio-visual content. The audio description file 134 may be in a variety of file formats, such as the ".wav" file format. The audio description data 136 may have one of a variety of coding formats, including a pulse-code modulation (PCM) signal, a linear PCM (LPCM) signal, an A-law PCM signal, etc.

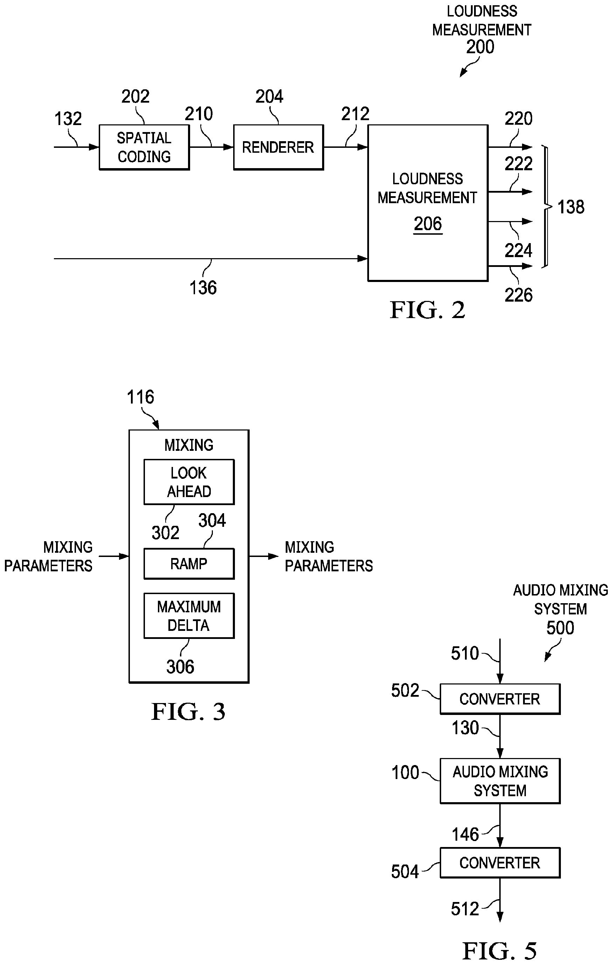

The loudness measurement component 114 receives the audio object data 132 and the audio description data 136, calculates various loudnesses, and generates loudness data 138. Specifically, the loudness measurement component calculates a long-term loudness of the audio object data 132, a long-term loudness of the audio description data 136, a number of short-term loudnesses of the audio object data 132, and a number of short-term loudnesses of the audio description data 136. In general, the time period of the long-term loudness is a multiple of the time period used for the short-term loudness. For example, the audio data may be formatted as audio samples (e.g., with sample rate of 48 kHz, 96 kHz, 192 kHz, etc.); the short-term loudness may be calculated on the basis of each sample, and the long-term loudness may be calculated over multiple samples. Multiple samples may be organized into frames (e.g., frame size of 0.5 ms, 0.833 ms, 1.0 ms, etc.), and the short-term loudness may be calculated on the basis of each frame. The long-term loudness may also be calculated over the entirety of the audio data. Further details of the loudness measurement component 114 are provided with reference to FIG. 2.

The mixing component 116 receives the audio object data 132, the audio description data 136 and the loudness data 138, applies gains, and generally performs the mixing process, as further described herein. The mixing component 116 also receives metadata 140, generates visualization data 142, generates metadata 144 and generates mixed audio object data 146. The metadata reader 118, the visualization component 120, the metadata writer 122, and the audio object writer 124 may be viewed as functional components of the mixing component 116 that operate on the inputs in order to generate the outputs.

The metadata reader 118 receives the metadata 140. In general, the metadata 140 corresponds to an initial set of mixing parameters (also referred to as default mixing parameters). As further discussed herein, the initial mixing parameters result in a set of gain adjustments, which the audio engineer may adjust as desired; the mixing parameters having been adjusted may be referred to as adjusted mixing parameters. The metadata 140 may be in various formats, such as the extensible markup language (XML) format, the JavaScript object notation (JSON) format, etc.

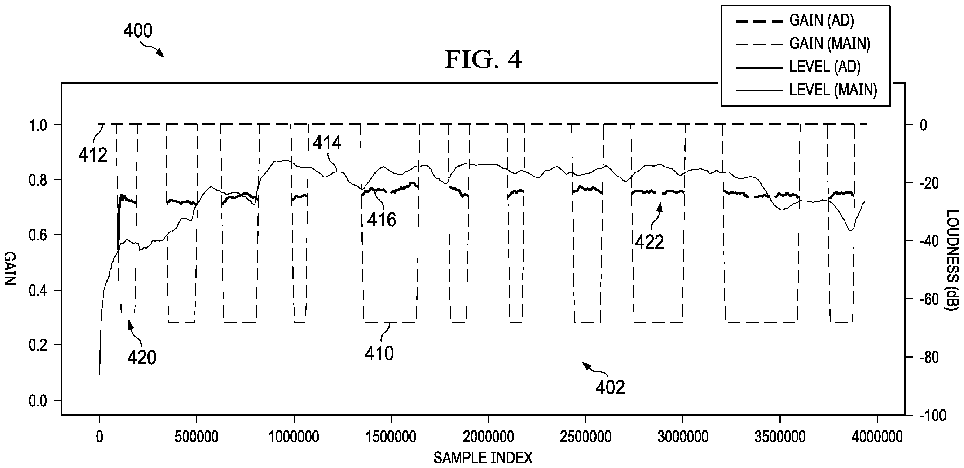

The visualization component 120 generates a gain adjustment visualization based on the mixing parameters and the loudness data 138. In general, the gain adjustment visualization shows the loudness of the audio object data 132, the loudness of the audio description data 136, and the gains to be applied for mixing according to the mixing parameters and the loudness data 138. The audio engineer may then use the gain adjustment visualization to evaluate the gains of the proposed mix and to adjust the gains as desired, resulting in the adjusted mixing parameters. Further details of the gain adjustment visualization are provided with reference to FIG. 4.

The metadata writer 122 generates the metadata 144. The metadata 144 corresponds to the mixing parameters and the loudness data 138. In the event that the default mixing parameters generate an acceptable audio mix, the parameters in the metadata 140 may be used as the parameters in the metadata 144 without any adjustment. However, generally the audio engineer will adjust the mixing parameters from the default parameters to generate the metadata 144. The mixing parameters and the loudness data 138 represented by the metadata 144 may be referred to as adjusted mixing parameters during the process of adjustment, and may be referred to as final mixing parameters once the audio engineer has completed adjustment of the gains.

The audio object writer 124 and the audio object metadata writer 148 work together to generate the mixed audio output. The audio object writer 124 mixes the audio object data 132 and the audio description data 136 according to the mixing parameters and the loudness data 138, and generates the mixed audio object data 146. The mixing parameters may be the initial mixing parameters or the adjusted mixing parameters. The mixed audio object data 146 then includes the gain-adjusted audio object data and the gain-adjusted audio description data. The mixed audio object data 146 may include audio objects, audio bed channels, etc. The audio object data 132 and the audio description data 136 may be mixed (including their gain adjustments) according to two options.

One option is to mix the audio description into one or more appropriate bed channels, according to the format of the audio description. For example, monaural audio description may be mixed into the center channel bed, stereo audio description may be mixed into the left and right channel beds, 5.1-channel audio description may be mixed into the 5.1-channel audio beds, etc. This option is useful when the total number of available audio objects is limited.

Another option is to create one or more new audio objects corresponding to the appropriate one or more locations corresponding to the format of the audio description. For example, an audio object located at a central location may be generated for monaural audio description, two audio objects located at respective left and right locations may be generated for stereo audio description, five audio objects located at the 5.1-channel surround locations may be generated for 5.1-channel audio description, etc.

The audio object metadata writer 126 generates audio object metadata 148 related to the mixed audio object data 146. For example, the audio object metadata 148 may include the position information for each audio object, the size information for each audio object, etc.

A brief overview of the operation of the audio mixing system 100 is as follows. The audio engineer selects an audio object file and an audio description file; the audio object reader 110 generates the corresponding audio object data 132, and the audio description reader generates the corresponding audio description data 136. The loudness measurement component 114 generates the loudness data 138. The mixing component 116 reads the metadata 140 and applies the mixing parameters to the loudness data 138 to generate the gain visualization data 142. The audio mixing system 100 displays the gain visualization data 142, and the audio engineer evaluates the gain visualization.

Based on the gain visualization, the audio engineer may adjust the gains; the mixing component 116 adjusts the mixing parameters to correspond to the adjusted gains and displays an adjusted gain visualization corresponding to the adjusted mixing parameters. The display, evaluation and adjustment process may be performed multiple times, iteratively, etc.

Once the mixing engineer's evaluation is complete (based either on the initial mixing parameters or on the adjusted mixing parameters), the mixing component 116 generates the metadata 144 corresponding to the final mixing parameters and generates the mixed audio object data 146 based on the final mixing parameters.

The mixing process performed using the audio mixing system 100 may result in the mixed audio being generated more quickly than existing mixing systems. For example, an audio mix using the initial mixing parameters for a 90-minute movie may be generated in 30 minutes.

Further details of the audio mixing system 100 are as follows.

FIG. 2 is a block diagram of a loudness measurement component 200. The loudness measurement component 200 may be used as the loudness measurement component 114 (see FIG. 1). The loudness measurement component 200 generally receives the audio object data 132 and the audio description data 136, performs loudness measurement, and generates the loudness data 138 (see FIG. 1). The loudness measurement component 200 includes a spatial coding component 202, a renderer 204, and a loudness measurer 206.

The spatial coding component 202 receives the audio object data 132, performs spatial coding, and generates clustered data 210. The audio object data 132 generally includes audio objects, with each audio object containing audio data and location metadata indicating where that audio data is to be output. The audio objects data 132 may also contain audio beds. The spatial coding component 202 performs spatial coding to reduce the number of objects and beds into a smaller number of clusters. For example, the audio objects data 132 may contain up to 128 objects and beds, which the spatial coding component groups into elements (also referred to as clusters). The clustered data 210 may contain a number of clusters, such as 12 or 16 clusters. The clusters may be in surround sound channel format, e.g. 11.1-channel format for 12 clusters, 15.1-channel format for 16 clusters, etc. In general, the spatial coding component 202 performs spatial coding by dynamically grouping audio objects into dynamic clusters, where an audio object may move from one cluster to another as the position information of the audio object changes, and a cluster may move as well.

The renderer 204 receives the clustered data 210, performs rendering, and generates rendered data 212. In general, the renderer 204 performs rendering by associating a cluster in the clustered data 210 to a channel in the rendered data 212. The rendered data 212 may be one of a variety of channel formats, including a monaural format (1 channel), a stereo format (two channels), a 5.1-channel surround format (6 channels), a 7.1-channel surround format (8 channels), etc. The rendered data 212 may have one of a variety of coding formats, including a pulse-code modulation (PCM) signal, a linear PCM (LPCM) signal, an A-law PCM signal, etc. According to a specific example embodiment, the rendered data 212 is a 5.1-channel LPCM signal.

The loudness measurer 206 receives the rendered data 212 and the audio description data 136, performs loudness measurement, generates long-term loudness data 220 and short-term loudness data 222 of the rendered data 212, and generates long-term loudness data 224 and short-term loudness data 226 of the audio description data 136. Collectively, the loudness data 220, 222, 224 and 226 correspond to the loudness data 138 (see FIG. 1).

The loudness measurer 206 may implement one of a number of loudness measurement processes. Example loudness measurement processes include the Leq (loudness equivalent continuous sound pressure level) process, the LKFS (loudness, K-weighted, relative to full scale) process, the LUFS (loudness units relative to full scale) process, etc.

The loudness measurer 206 may be implemented by a computer program such as the Dolby^{™} Professional Loudness Measurement (DPLM) development kit. The loudness measurer 206 calculates the long-term loudness data 220 and 224 in order to determine overall level of this input; this value may be used to normalize the inputs (referred to as dialog normalization or "dialnorm") so that there is not a disturbing loudness difference between the rendered data 212 and the audio description data 136. An example target value for dialog normalization is -31 dB.

In general, the short-term loudness data 222 and 226 correspond to time-ordered data, where each loudness measurement corresponds to the loudness of a particular portion of the input (e.g., sample, frame, etc.). In general, the long-term loudness data 220 and 224 corresponds to the overall loudness of each respective input, but if they are calculated over multiple portions of the input, they may be time-ordered data as well. The loudness data 138 may be formatted in a hierarchical format, e.g. as extensible markup language (XML) data.

FIG. 3 is a block diagram showing additional components of the mixing component 116 (see FIG. 1). These additional components are generally used when processing the loudness data 138 according to the mixing parameters. The additional components include a lookahead component 302, a ramp component 304, and a maximum delta component 306. The mixing component 116 may include components for processing other mixing parameters, as desired.

The mixing parameters are initially provided in the metadata 140 (see FIG. 1). There may be a number of initial sets of mixing parameters that are available for selection by the mixing engineer, for example that correspond to various genres of audio-visual content. The mixing engineer then selects the set of mixing parameters that correspond to the genre of the audio object file 134, and these initial parameters are provided to the mixing component 116 as the metadata 140. Example genres include an action genre, a horror genre, a suspense genre, a news genre, a conversational genre, a sports genre, and a talk-show genre.

An example of the initial set of mixing parameters contained in the metadata 140 for the action genre is given in TABLE 1:

**TABLE 1**

| Parameter (units) | Value |
|---|---|
| Lookahead length for main audio (s) | 1.0 |
| Ramp start offset (s) | -0.192 |
| Ramp end offset (s) | -0.192 |
| Target maximum delta (dB) | 30 |
| Minimum gain | 0.4 |
| Lookahead length for audio description (s) | 2.0 |

The lookahead component 302 processes the lookahead parameters. The lookahead length for main audio corresponds to the forward-looking time period that the mixing component 116 uses when processing the loudness data 138, for ducking the main audio when the audio description is present. If the audio description has stopped and starts again before the value of this parameter (e.g., 1.0 second), the ramp is not released during the stoppage period. (Examples are shown in FIG. 4 and are discussed in more detail there.) This parameter prevents the loudness of the main audio from large fluctuations that might otherwise occur during brief pauses in the audio description. This parameter may differ for other genres; for example, it may be increased (e.g., 2.0 seconds) for the news genre.

The lookahead length for audio description corresponds to the forward-looking time period that the mixing component 116 uses when processing the loudness data 138, for tuning the value of the gain for the audio description. For example, the lookahead component 302 may process the short-term loudness data 226 (see FIG. 2) of the audio description over the upcoming time period corresponding to the value of this parameter (e.g., 2.0 seconds), and based on that processing may increase or decrease the gain to be applied to the audio description. As another example, the lookahead component 302 may process both the short-term loudness data 226 of the audio description and the short-term loudness data 222 of the main audio over the upcoming time period corresponding to the value of this parameter (e.g., 2.0 seconds), and based on that processing may increase or decrease the gain to be applied to both the audio description and the main audio.

The ramp component 304 processes the ramp parameters. The ramp start offset corresponds to the length of time over which, when the audio description begins, the gain to the main audio is gradually applied. This gain is gradually applied, and is not applied instantaneously, in order to reduce the likelihood that the decrease in the main audio disrupts the listener experience. For example, when the gain to be applied to the main audio is 0.3 when mixing the audio description, the gain is not instantaneously changed from 1.0 to 0.3, but is gradually changed over the ramp start offset period. For the action genre, the time period of 0.192 seconds works well. This period may be adjusted for other genres. For example, a greater time period (e.g., 0.384 seconds) works well for the drama genre.

The ramp end offset corresponds to the length of time over which, when the audio description ends, the gain to the main audio is gradually released. For example, when the gain of 0.3 has been applied during the audio description, the gain is gradually increased back to 1.0 over the ramp end offset period (e.g., 0.192 seconds). The ramp end offset period may differ from the ramp start offset period, or they may be the same. For the action genre, the time period of 0.192 seconds works well. This period may be adjusted for other genres. For example, a greater time period (e.g., 0.384 seconds) works well for the drama genre.

The maximum delta component 306 processes the target maximum delta and minimum gain parameters. The target maximum delta corresponds to the difference in the loudness level between the main audio and the audio description over which the gain will be applied to the main audio. If the loudness difference is less than this level, no gain will be applied to the main audio, even if audio description is present. This feature is useful when there is a quiet scene with background music, and the audio description is present; if the main audio is ducked, the background music may not be heard over the audio description, disrupting the director's intent for the audio scene.

The minimum gain corresponds to the minimum gain applied to the audio description. This value prevents the audio description from being too loud compared to the main audio; for example in an otherwise quiet scene, the audio description may be so loud that it disrupts the listeners immersion in the audio scene. Ducking the audio description in these extreme cases allows the listener to be immersed in the audio scene.

As mentioned above, the parameters in TABLE 1 are an initial set of parameters that are provided to the mixing component 116 via the metadata 140. The correspond to a genre, and the audio mixing system 100 may store a number of sets of mixing parameters, each corresponding to one of a number of genres. In addition, the values of the parameters used as the initial parameters may be adjusted as well. For example, for the action genre (see TABLE 1), the ramp start offset value may be changed from -0.192 to -0.182. The value of -0.182 is then used as one of the initial parameters provided via the metadata 140. This allows the mixing engineer to adjust the default mixing parameters before they are input into the mixing component 116. Furthermore, there may be multiple sets of parameters for a given genre. For example, for the action genre, one set of parameters may have a ramp start offset value of -0.190, and another set of parameters may have a ramp start offset value of -0.195.

The audio mixing system 100 may process other mixing parameters than those detailed in TABLE 1. For example, a default main audio ducking parameter may set the default gain value to be applied when ducking the main audio. This parameter may be defined as a gain level (e.g., a gain of 0.3), as a decibel level (e.g., -16 dB), etc. As another example, enabling the minimum gain parameter for ducking the audio description (as discussed above) is an artistic choice that may be toggled on or off according to a parameter.

FIG. 4 is a graph 400 showing a visualization 402 of the visualization data 142 (see FIG. 1). In the graph 400, the x-axis is the sample index of the main audio data (e.g., the audio object data 132) and of the audio description data (e.g., the audio description data 136). The x-axis may be viewed as a time index, with the beginning of the content to the left at zero and the end of the content to the right. The y-axis on the left shows the gain to be applied to the main audio and to the audio description, and on the right shows the loudness level (in dB) of the main audio and of the audio description.

The visualization 402 is an example for a selected audio object file (e.g., 130) and a selected audio description file (e.g., 134), showing the gains and loudnesses. The gains are shown with dashed lines; the line 410 shows the gain to be applied to the main audio, and the line 412 shows the gain to be applied to the audio description. As discussed above, these gains correspond to the mixing parameters applied to the loudness data 138 (see FIG. 1). The loudness levels are the lines 414 and 416; the line 414 shows the loudness of the main audio, and the line 416 shows the loudness of the audio description. Note that the line 416 is discontinuous; where the line 416 is not present, the audio description is not present.

The visualization 402 shows a number of features. Note that the gain to be applied to the audio description (the line 412) is constant at 1.0. This indicates that the mixing component 116, upon consideration of the mixing parameters and the loudness data 138, determines that no gain adjustment needs to be applied to the audio description. For example, a comparison of the overall loudnesses between the main audio and the audio description may be within the value defined by the mixing parameters.

Note that the gain to be applied to the main audio (the line 410) mainly ranges between 1.0 and 0.3, except around point 420. The ramp down from 1.0 to 0.3, and the ramp up from 0.3 to 1.0, are not easily seen due to the scale of the x-axis, but they are present according to the mixing parameters of the ramp start offset and the ramp end offset (see TABLE 1). Furthermore, note that the gain of 0.3 may be configured using the mixing parameters, for example using the default main audio ducking parameter. Around point 420, the gain to be applied is approximately 0.32; this is the result of an interaction between the mixing parameters as applied to the short-term loudnesses. For example, the default parameters may result in this gain, or the mixing engineer may adjust the mixing parameters such that this gain results (e.g., in response to listening to the mixed audio, to generate a more acceptable mix).

Note that the gain to be applied to the main audio (the line 410) is generally present when the audio description is present (the line 416). However, the line 410 is also present at some indices where the audio description is not present, such as around the point 422. This indicates a brief break in the audio description that is less than the lookahead length value defined in the mixing parameters (see TABLE 1).

The mixing engineer may use the visualization 402 to evaluate the proposed gains to be applied in the mix. For example, the default parameters result in a first visualization, which the mixing engineer evaluates. If the first visualization appears to indicate an acceptable mix will result, the mixing engineer may instruct the audio mixing system 100 to generate the audio mix without any adjustment. However, if the first visualization shows some discontinuities or other visual features that indicate an unacceptable mix would result, the mixing engineer may adjust the mixing parameters, and the audio mixing system 100 may generate a second visualization based on the adjusted parameters. (For example, the mixing parameters may be adjusted to result in the slightly different appearance of the line 410 around the point 420.) The process of displaying the revised visualization, evaluating the revised visualization, and adjusting the mixing parameters may be performed iteratively (or otherwise multiple times) until the visual features of the revised visualization indicate that an acceptable mix would result.

In addition, recall that the metadata 144 corresponding to the final mixing parameters is generated around the time when the mixed audio object data 146 is generated. This allows the mixing engineer to evaluate the mixed audio; if it is unacceptable, the mixing engineer may instruct the audio mixing system 100 to use the metadata 144 as the input to the mixing component 116 (e.g., as the mixing parameters 140), and may then perform the evaluation and adjustment based on adjusted parameters instead of the default parameters.

FIG. 5 is a block diagram of an audio mixing system 500. As compared to the audio mixing system 100 (see FIG. 1) that is described as processing object audio, the audio mixing system 500 may be used to process other types of audio. The audio mixing system 500 includes a converter 502, the audio mixing system 100, and a converter 504.

The converter 502 receives audio data 510, converts the audio data 510, and generates audio object data (e.g., the audio object file 130, the audio object data 132, etc.). The audio data 510 generally corresponds to audio data that does not include an audio object, and the converter 502 performs conversion to convert the audio data 510 to object audio data. For example, the audio data 510 may be in Ambisonics format, and the audio object file 130 may be in Dolby Atmos^{™} format; the converter 502 may implement an Ambisonics to Dolby Atmos^{™} conversion. The audio data 510 may generally correspond to the main audio of audio-visual content (e.g., a movie soundtrack).

The audio mixing system 100 processes the audio object file 130 (resulting from the conversion), and generates the mixed audio object data 146 and the audio object metadata 148, as discussed above.

The converter 504 receives the mixed audio object data 146, converts the mixed audio object data 146, and generates mixed audio data 512. The converter 504 may also receive the mixed audio object data 148. The mixed audio data 512 then corresponds to the audio description mixed with the audio data 510. In general, the converter 504 performs an inverse of the conversion performed by the converter 502. For example, when the converter 502 implements an Ambisonics to Dolby Atmos^{™} conversion, the converter 504 implements a Dolby Atmos^{™} to Ambisonics conversion.

In this manner, the audio mixing system 500 enables the audio mixing system 100 to be used with other types of audio.

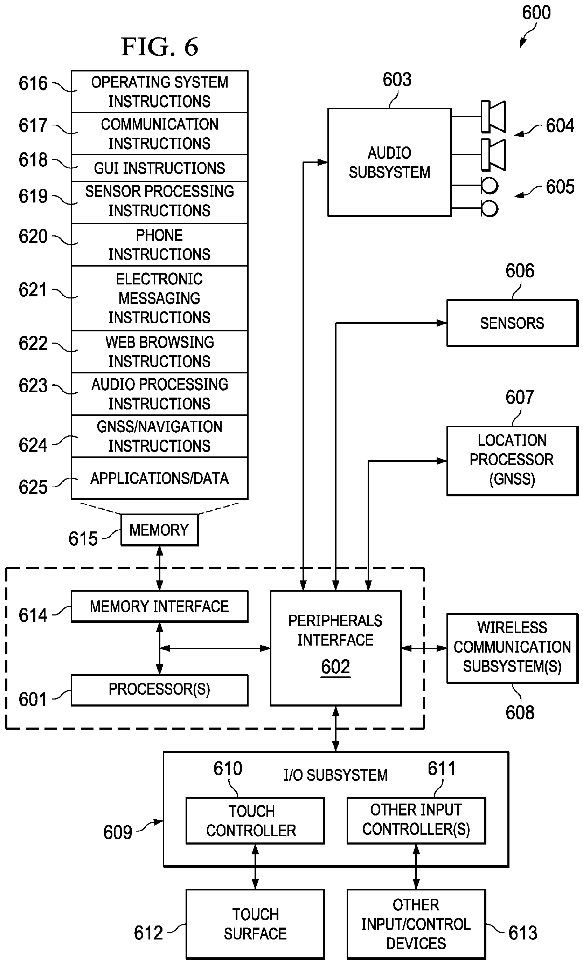

FIG. 6 is a device architecture 600 for implementing the features and processes described herein, according to an embodiment. The architecture 600 may be implemented in any electronic device, including but not limited to: a desktop computer, consumer audio/visual (AV) equipment, radio broadcast equipment, mobile devices (e.g., smartphone, tablet computer, laptop computer, wearable device), etc. In the example embodiment shown, the architecture 600 is for a laptop computer and includes processor(s) 601, peripherals interface 602, audio subsystem 603, loudspeakers 604, microphone 605, sensors 606 (e.g., accelerometers, gyros, barometer, magnetometer, camera), location processor 607 (e.g., GNSS receiver), wireless communications subsystems 608 (e.g., Wi-Fi, Bluetooth, cellular) and I/O subsystem(s) 609, which includes touch controller 610 and other input controllers 611, touch surface 612 and other input/control devices 613. Other architectures with more or fewer components can also be used to implement the disclosed embodiments.

Memory interface 614 is coupled to processors 601, peripherals interface 602 and memory 615 (e.g., flash, RAM, ROM). Memory 615 stores computer program instructions and data, including but not limited to: operating system instructions 616, communication instructions 617, GUI instructions 618, sensor processing instructions 619, phone instructions 620, electronic messaging instructions 621, web browsing instructions 622, audio processing instructions 623, GNSS/navigation instructions 624 and applications/data 625. Audio processing instructions 623 include instructions for performing the audio processing described herein.

As a specific example, the device architecture 600 may implement the audio mixing system 100 (see FIG. 1), for example by executing one or more computer programs. The device architecture may access the audio file 130 via the peripherals interface 602 (e.g., connected to a non-volatile storage such as a solid-state drive), may calculate the loudness data 138 using the processors 601, may display the visualization data 142 via the peripherals interface 602 (e.g., connected to a display device), and may generate the mixed audio object data 146 using the processors 601.

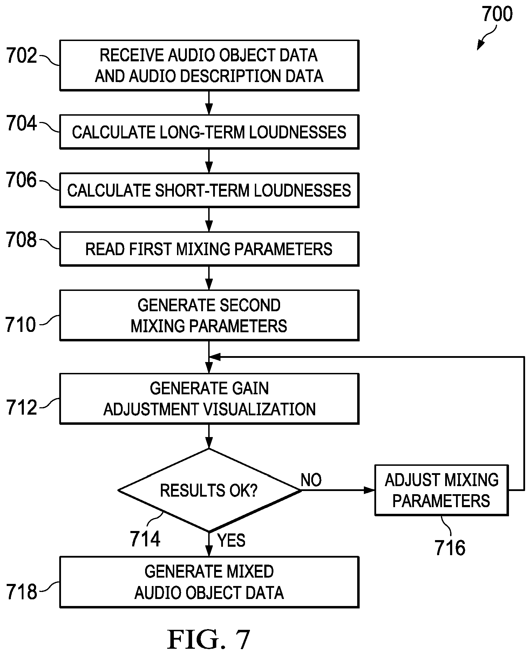

FIG. 7 is a flowchart of a method 700 of audio processing. The method 700 may be performed by a device (e.g., a laptop computer, a desktop computer, etc.) with the components of the architecture 600 of FIG. 6, to implement the functionality of the audio mixing system 100 (see FIG. 1), etc., for example by executing one or more computer programs.

At 702, audio object data and audio description data is received. The audio object data includes a first set of audio objects. For example, the loudness measurement component 114 and the mixing component 116 (see FIG. 1) may receive the audio object data 132 and the audio description data 136.

At 704, calculating a long-term loudness of the audio object data and a long-term loudness of the audio description data are calculated. For example, the loudness measurement component 114 (see FIG. 1) may calculate the long-term loudnesses as part of the loudness data 138. The long-term loudnesses may be calculated over the entirety of the data.

At 706, a number of short-term loudnesses of the audio object data and a number of short-term loudnesses of the audio description data are calculated. For example, the loudness measurement component 114 (see FIG. 1) may calculate the short-term loudnesses as part of the loudness data 138. The short-term loudnesses may be calculated on a continuous basis, e.g. per sample, per frame, etc.

At 708, a first set of mixing parameters that correspond to the audio object data are read. For example, the metadata reader 118 (see FIG. 1) may read the metadata 140 that contains the initial mixing parameters.

At 710, a second set of mixing parameters are generated based on the first set of mixing parameters, the long-term loudness of the audio object data, the long-term loudness of the audio description data, the short-term loudnesses of the audio object data, and the short-term loudnesses of the audio description data. For example, the mixing component 116 (see FIG. 1) may process the loudness data 138 according to the initial mixing parameters to generate a set of proposed gains for the main audio and the audio description (e.g., that correspond to the lines 410 and 412 in FIG. 4).

At 712, a gain adjustment visualization is generated. The gain adjustment visualization corresponds to the second set of mixing parameters, the audio object data and the audio description data. For example, the gain adjustment visualization may correspond to the visualization 402 (see FIG. 4) that shows the loudness of the main audio, the loudness of the audio description, and the proposed gains.

At 714, the gain adjustment visualization is evaluated to determine whether applying the mixing parameters would generate acceptable results. For example, the mixing engineer may evaluate the visualization 402 (see FIG. 4). If the results are not acceptable, the flow proceeds to 716; if the results are acceptable, the flow proceeds to 718.

At 716, the second set of mixing parameters are adjusted. For example, the mixing engineer may adjust the proposed gains, and the mixing component 116 may adjust the mixing parameters accordingly to correspond to the adjusted gains.

At 718, mixed audio object data is generated by mixing the audio object data and the audio description data according to the second set of mixing parameters. The mixed audio object data includes a second set of audio objects, where the second set of audio objects correspond to the first set of audio objects mixed with the audio description data according to the second set of mixing parameters. For example, the audio object writer 124 (see FIG. 1) may generate the mixed audio object data 146. The audio object metadata related to the mixed audio object data may also be generated. For example, the audio object metadata writer 126 may generate the audio object metadata 148.

The method 700 may include additional steps corresponding to the other functionalities of the audio mixing system 100, etc. as described herein. For example, the default mixing parameters may be selected based on the genre of the audio-visual content being mixed. The mixing parameters may include a lookahead parameter, a ramp parameter, a maximum delta parameter, etc. The method 700 may include conversion steps to convert non-object audio to object audio for processing by the audio mixing system 100, and to convert the mixed object audio to mixed non-object audio.

### Additional Details

Although the description has focused on mixing audio description, embodiments may also be used to mix other types of audio content, to achieve similar improvements in time, effort and efficiency. For example, the audio mixing system 100 (see FIG. 1) may be used to mix the director's commentary.

### Implementation Details

An embodiment may be implemented in hardware, executable modules stored on a computer readable medium, or a combination of both (e.g., programmable logic arrays). Unless otherwise specified, the steps executed by embodiments need not inherently be related to any particular computer or other apparatus, although they may be in certain embodiments. In particular, various general-purpose machines may be used with programs written in accordance with the teachings herein, or it may be more convenient to construct more specialized apparatus (e.g., integrated circuits) to perform the required method steps. Thus, embodiments may be implemented in one or more computer programs executing on one or more programmable computer systems each comprising at least one processor, at least one data storage system (including volatile and non-volatile memory and/or storage elements), at least one input device or port, and at least one output device or port. Program code is applied to input data to perform the functions described herein and generate output information. The output information is applied to one or more output devices, in known fashion.

Each such computer program is preferably stored on or downloaded to a storage media or device (e.g., solid state memory or media, or magnetic or optical media) readable by a general or special purpose programmable computer, for configuring and operating the computer when the storage media or device is read by the computer system to perform the procedures described herein. The inventive system may also be considered to be implemented as a computer-readable storage medium, configured with a computer program, where the storage medium so configured causes a computer system to operate in a specific and predefined manner to perform the functions described herein. (Software per se and intangible or transitory signals are excluded to the extent that they are unpatentable subject matter.)

Aspects of the systems described herein may be implemented in an appropriate computer-based sound processing network environment for processing digital or digitized audio files. Portions of the adaptive audio system may include one or more networks that comprise any desired number of individual machines, including one or more routers (not shown) that serve to buffer and route the data transmitted among the computers. Such a network may be built on various different network protocols, and may be the Internet, a Wide Area Network (WAN), a Local Area Network (LAN), or any combination thereof.

One or more of the components, blocks, processes or other functional components may be implemented through a computer program that controls execution of a processor-based computing device of the system. It should also be noted that the various functions disclosed herein may be described using any number of combinations of hardware, firmware, and/or as data and/or instructions embodied in various machine-readable or computer-readable media, in terms of their behavioral, register transfer, logic component, and/or other characteristics. Computer-readable media in which such formatted data and/or instructions may be embodied include, but are not limited to, physical (non-transitory), non-volatile storage media in various forms, such as optical, magnetic or semiconductor storage media.

The above description illustrates various embodiments of the present disclosure along with examples of how aspects of the present disclosure may be implemented. The above examples and embodiments should not be deemed to be the only embodiments, and are presented to illustrate the flexibility and advantages of the present disclosure as defined by the following claims. Based on the above disclosure and the following claims, other arrangements, embodiments and implementations will be evident to those skilled in the art and may be employed without departing from the scope of the disclosure as defined by the claims.

## Claims

1. A computer-implemented method (700) of audio processing, the method comprising:
receiving (702) audio object data (132) and audio description data (136), wherein the audio object data includes a first plurality of audio objects;
calculating (704) a long-term loudness of the audio object data and a long-term loudness of the audio description data;
calculating (706) a plurality of short-term loudnesses of the audio object data and a plurality of short-term loudnesses of the audio description data;
reading (708) a first plurality of mixing parameters that correspond to the audio object data;
generating (710) a second plurality of mixing parameters based on the first plurality of mixing parameters, the long-term loudness of the audio object data, the long-term loudness of the audio description data, the plurality of short-term loudnesses of the audio object data, and the plurality of short-term loudnesses of the audio description data;
generating (712) a gain adjustment visualization corresponding to the second plurality of mixing parameters, the audio object data and the audio description data; and
generating (718) mixed audio object data (146) by mixing the audio object data and the audio description data according to the second plurality of mixing parameters, wherein the mixed audio object data includes a second plurality of audio objects, wherein the second plurality of audio objects correspond to the first plurality of audio objects mixed with the audio description data according to the second plurality of mixing parameters.

2. The method of claim 1, wherein the long-term loudness of the audio object data (132) is calculated over multiple samples of the audio object data, wherein the long-term loudness of the audio description data (136) is calculated over multiple samples of the audio description data,
wherein each of the plurality of short-term loudnesses of the audio object data (132) is calculated over a single sample of the audio object data, and wherein each of the plurality of short-term loudnesses of the audio description data (136) is calculated over a single sample of the audio description data.

3. The method of any one of claims 1-2, wherein the first plurality of mixing parameters is associated with one of a plurality of genres, wherein each of the plurality of genres is associated with a corresponding set of mixing parameters.

4. The method of any one of claims 1-3, wherein the first plurality of mixing parameters includes a lookahead parameter, a ramp parameter and a maximum delta parameter.

5. The method of claim 4, wherein the lookahead parameter corresponds to maintaining a uniform gain adjustment during an audio pause in the audio description data (136).

6. The method of any one of claims 4-5, wherein the ramp parameter corresponds to a time period over which a gain adjustment is gradually applied.

7. The method of any one of claims 4-6, wherein the maximum delta parameter corresponds to a maximum loudness difference between a frame of the audio object data (132) and a corresponding frame of the audio description data (136).

8. The method of any one of claims 1-7, further comprising:
receiving a user input to adjust the second plurality of mixing parameters, prior to generating the mixed audio object data; and
generating a revised gain adjustment visualization corresponding to the second plurality of mixing parameters having been adjusted according to the user input,
wherein the mixed audio object data is generated based on the second plurality of mixing parameters having been adjusted.

9. The method of any one of claims 1-8, further comprising:
prior to receiving the audio object data (132):
receiving audio data (510), wherein the audio data does not include an audio object; and
converting the audio data into the audio object data, and
after generating the mixed audio object data:
converting the mixed audio object data to mixed audio data, wherein the mixed audio data corresponds to the audio data mixed with the audio description data.

10. A non-transitory computer readable medium (615) storing a computer program that, when executed by a processor (601), controls an apparatus (600) to execute processing including the method of any one of claims 1-9.

11. An apparatus (600) for audio processing, the apparatus comprising:
a processor (601),
wherein the processor is configured to control the apparatus to receive audio object data and audio description data, wherein the audio object data includes a first plurality of audio objects,
wherein the processor is configured to control the apparatus to calculate a long-term loudness of the audio object data and a long-term loudness of the audio description data,
wherein the processor is configured to control the apparatus to calculate a plurality of short-term loudnesses of the audio object data and a plurality of short-term loudnesses of the audio description data,
wherein the processor is configured to control the apparatus to read a first plurality of mixing parameters that correspond to the audio object data,
wherein the processor is configured to control the apparatus to generate a second plurality of mixing parameters based on the first plurality of mixing parameters, the long-term loudness of the audio object data, the long-term loudness of the audio description data, the plurality of short-term loudnesses of the audio object data, and the plurality of short-term loudnesses of the audio description data,
wherein the processor is configured to control the apparatus to generate a gain adjustment visualization corresponding to the second plurality of mixing parameters, the audio object data and the audio description data, and
wherein the processor is configured to control the apparatus to generate mixed audio object data by mixing the audio object data and the audio description data according to the second plurality of mixing parameters, wherein the mixed audio object data includes a second plurality of audio objects, wherein the second plurality of audio objects correspond to the first plurality of audio objects mixed with the audio description data according to the second plurality of mixing parameters.

12. The apparatus (600) of claim 11, further comprising:
a display (602) that is configured to display the gain adjustment visualization.

13. The apparatus (600) of any one of claims 11-12, wherein the long-term loudness of the audio object data is calculated over multiple samples of the audio object data, wherein the long-term loudness of the audio description data is calculated over multiple samples of the audio description data,
wherein each of the plurality of short-term loudnesses of the audio object data is calculated over a single sample of the audio object data, and wherein each of the plurality of short-term loudnesses of the audio description data is calculated over a single sample of the audio description data.

14. The apparatus (600) of any one of claims 11-13, wherein the first plurality of mixing parameters is associated with one of a plurality of genres, wherein each of the plurality of genres is associated with a corresponding set of mixing parameters.

15. The apparatus (600) of any one of claims 11-14, wherein the first plurality of mixing parameters includes a lookahead parameter, a ramp parameter and a maximum delta parameter.

## Patentansprüche

1. Computerimplementiertes Verfahren (700) für Audioverarbeitung, wobei das Verfahren umfasst:
Empfangen (702) von Audioobjektdaten (132) und Audiobeschreibungsdaten (136), wobei die Audioobjektdaten eine erste Vielzahl von Audioobjekten beinhalten;
Berechnen (704) einer Langzeitlautstärke der Audioobjektdaten und einer Langzeitlautstärke der Audiobeschreibungsdaten;
Berechnen (706) einer Vielzahl von Kurzzeitlautstärken der Audioobjektdaten und einer Vielzahl von Kurzzeitlautstärken der Audiobeschreibungsdaten;
Lesen (708) einer ersten Vielzahl von Mischparametern, die den Audioobjektdaten entsprechen;
Erzeugen (710) einer zweiten Vielzahl von Mischparametern auf Grundlage der ersten Vielzahl von Mischparametern, der Langzeitlautstärke der Audioobjektdaten, der Langzeitlautstärke der Audiobeschreibungsdaten, der Vielzahl von Kurzzeitlautstärken der Audioobjektdaten und der Vielzahl von Kurzzeitlautstärken der Audiobeschreibungsdaten;
Erzeugen (712) einer Visualisierung der Verstärkungseinstellung entsprechend der zweiten Vielzahl von Mischparametern, den Audioobjektdaten und den Audiobeschreibungsdaten; und Erzeugen (718) gemischter Audioobjektdaten (146) durch Mischen der Audioobjektdaten und der Audiobeschreibungsdaten gemäß der zweiten Vielzahl von Mischparametern, wobei die gemischten Audioobjektdaten eine zweite Vielzahl von Audioobjekten beinhalten, wobei die zweite Vielzahl von Audioobjekten der ersten Vielzahl von Audioobjekten entspricht, die mit den Audiobeschreibungsdaten gemäß der zweiten Vielzahl von Mischparametern gemischt sind.

2. Verfahren nach Anspruch 1, wobei die Langzeitlautstärke der Audioobjektdaten (132) über mehrere Abtastwerte der Audioobjektdaten berechnet wird, wobei die Langzeitlautstärke der Audiobeschreibungsdaten (136) über mehrere Abtastwerte der Audiobeschreibungsdaten berechnet wird,
wobei jede der Vielzahl von Kurzzeitlautstärken der Audioobjektdaten (132) über einen einzelnen Abtastwert der Audioobjektdaten berechnet wird, und wobei jede der Vielzahl von Kurzzeitlautstärken der Audiobeschreibungsdaten (136) über einen einzelnen Abtastwert der Audiobeschreibungsdaten berechnet wird.

3. Verfahren nach einem der Ansprüche 1-2, wobei die erste Vielzahl von Mischparametern einem aus einer Vielzahl von Genres zugeordnet ist, wobei jedes aus der Vielzahl von Genres einem entsprechenden Satz von Mischparametern zugeordnet ist.

4. Verfahren nach einem der Ansprüche 1-3, wobei die erste Vielzahl von Mischparametern einen Lookahead-Parameter, einen Rampenparameter und einen Maximum-Delta-Parameter beinhaltet.

5. Verfahren nach Anspruch 4, wobei der Lookahead-Parameter der Beibehaltung einer einheitlichen Verstärkungseinstellung während einer Audiopause in den Audiobeschreibungsdaten (136) entspricht.

6. Verfahren nach einem der Ansprüche 4-5, wobei der Rampenparameter einem Zeitraum entspricht, über den eine Verstärkungseinstellung allmählich vorgenommen wird.

7. Verfahren nach einem der Ansprüche 4-6, wobei der Maximum-Delta-Parameter einer maximalen Lautstärkedifferenz zwischen einem Frame der Audioobjektdaten (132) und einem entsprechenden Frame der Audiobeschreibungsdaten (136) entspricht.

8. Verfahren nach einem der Ansprüche 1-7, weiter umfassend:
Empfangen einer Benutzereingabe, um die zweite Vielzahl von Mischparametern einzustellen, bevor die gemischten Audioobjektdaten erzeugt werden; und
Erzeugen einer überarbeiteten Visualisierung der Verstärkungseinstellung entsprechend der zweiten Vielzahl von Mischparametern, die gemäß der Benutzereingabe eingestellt wurden,
wobei die gemischten Audioobjektdaten auf Grundlage der zweiten Vielzahl von Mischparametern, die eingestellt wurden, erzeugt werden.

9. Verfahren nach einem der Ansprüche 1-8, weiter umfassend:
vor dem Empfang der Audioobjektdaten (132):
Empfangen von Audiodaten (510), wobei die Audiodaten kein Audioobjekt beinhalten; und
Konvertieren der Audiodaten in die Audioobjektdaten, und
nach Erzeugen der gemischten Audioobjektdaten:
Konvertieren der gemischten Audioobjektdaten in gemischte Audiodaten, wobei die gemischten Audiodaten den mit den Audiobeschreibungsdaten gemischten Audiodaten entsprechen.

10. Nichtflüchtiges computerlesbares Medium (615), das ein Computerprogramm speichert, das, wenn es von einem Prozessor (601) ausgeführt wird, eine Einrichtung (600) steuert, Verarbeitung auszuführen, die das Verfahren nach einem der Ansprüche 1-9 beinhaltet.

11. Einrichtung (600) zur Audioverarbeitung, wobei die Einrichtung umfasst:
einen Prozessor (601),
wobei der Prozessor so konfiguriert ist, dass er die Einrichtung so steuert, dass sie Audioobjektdaten und Audiobeschreibungsdaten empfängt, wobei die Audioobjektdaten eine erste Vielzahl von Audioobjekten beinhalten,
wobei der Prozessor so konfiguriert ist, dass er die Einrichtung so steuert, dass sie eine Langzeitlautstärke der Audioobjektdaten und eine Langzeitlautstärke der Audiobeschreibungsdaten berechnet,
wobei der Prozessor so konfiguriert ist, dass er die Einrichtung so steuert, dass sie eine Vielzahl von Kurzzeitlautstärken der Audioobjektdaten und eine Vielzahl von Kurzzeitlautstärken der Audiobeschreibungsdaten berechnet,
wobei der Prozessor so konfiguriert ist, dass er die Einrichtung so steuert, dass sie eine erste Vielzahl von Mischparametern liest, die den Audioobjektdaten entsprechen,
wobei der Prozessor so konfiguriert ist, dass er die Einrichtung so steuert, dass sie eine zweite Vielzahl von Mischparametern auf Grundlage der ersten Vielzahl von Mischparametern, der Langzeitlautstärke der Audioobjektdaten, der Langzeitlautstärke der Audiobeschreibungsdaten, der Vielzahl von Kurzzeitlautstärken der Audioobjektdaten und der Vielzahl von Kurzzeitlautstärken der Audiobeschreibungsdaten erzeugt,
wobei der Prozessor so konfiguriert ist, dass er die Einrichtung so steuert, dass sie eine Visualisierung der Verstärkungseinstellung entsprechend der zweiten Vielzahl von Mischparametern, den Audioobjektdaten und den Audiobeschreibungsdaten erzeugt, und
wobei der Prozessor so konfiguriert ist, dass er die Einrichtung so steuert, dass sie gemischte Audioobjektdaten erzeugt, durch Mischen der Audioobjektdaten und der Audiobeschreibungsdaten gemäß der zweiten Vielzahl von Mischparametern, wobei die gemischten Audioobjektdaten eine zweite Vielzahl von Audioobjekten beinhalten, wobei die zweite Vielzahl von Audioobjekten der ersten Vielzahl von Audioobjekten entspricht, die mit den Audiobeschreibungsdaten gemäß der zweiten Vielzahl von Mischparametern gemischt sind.

12. Einrichtung (600) nach Anspruch 11, weiter umfassend:
eine Anzeige (602), die so konfiguriert ist, dass sie die Visualisierung der Verstärkungseinstellung anzeigt.

13. Einrichtung (600) nach einem der Ansprüche 11-12, wobei die Langzeitlautstärke der Audioobjektdaten über mehrere Abtastwerte der Audioobjektdaten berechnet wird, wobei die Langzeitlautstärke der Audiobeschreibungsdaten über mehrere Abtastwerte der Audiobeschreibungsdaten berechnet wird,
wobei jede der Vielzahl von Kurzzeitlautstärken der Audioobjektdaten über einen einzelnen Abtastwert der Audioobjektdaten berechnet wird, und wobei jede der Vielzahl von Kurzzeitlautstärken der Audiobeschreibungsdaten über einen einzelnen Abtastwert der Audiobeschreibungsdaten berechnet wird.

14. Einrichtung (600) nach einem der Ansprüche 11-13, wobei die erste Vielzahl von Mischparametern einem aus einer Vielzahl von Genres zugeordnet ist, wobei jedes aus der Vielzahl von Genres einem entsprechenden Satz von Mischparametern zugeordnet ist.

15. Einrichtung (600) nach einem der Ansprüche 11-14, wobei die erste Vielzahl von Mischparametern einen Lookahead-Parameter, einen Rampenparameter und einen Maximum-Delta-Parameter beinhaltet.

## Revendications

1. Procédé mis en oeuvre par ordinateur (700) de traitement audio, le procédé comprenant les étapes consistant à :
recevoir (702) des données d'objet audio (132) et des données de description audio (136), dans lequel les données d'objet audio incluent une première pluralité d'objets audio ;
calculer (704) une intensité sonore à long terme des données d'objet audio et une intensité sonore à long terme des données de description audio ;
calculer (706) une pluralité d'intensités sonores à court terme des données d'objet audio et une pluralité d'intensités sonores à court terme des données de description audio ;
lire (708) une première pluralité de paramètres de mixage qui correspondent aux données d'objet audio ;
générer (710) une seconde pluralité de paramètres de mixage sur la base de la première pluralité de paramètres de mixage, de l'intensité sonore à long terme des données d'objet audio, de l'intensité sonore à long terme des données de description audio, de la pluralité d'intensités sonores à court terme des données d'objet audio et de la pluralité d'intensités sonores à court terme des données de description audio ;
générer (712) une visualisation d'ajustement de gain correspondant à la seconde pluralité de paramètres de mixage, aux données d'objet audio et aux données de description audio ; et générer (718) des données d'objet audio mixées (146) en mélangeant les données d'objet audio et les données de description audio selon la seconde pluralité de paramètres de mixage, dans lequel les données d'objet audio mixées incluent une seconde pluralité d'objets audio, dans lequel la seconde pluralité d'objets audio correspondent à la première pluralité d'objets audio mixées avec les données de description audio selon la seconde pluralité de paramètres de mixage.

2. Procédé selon la revendication 1, dans lequel l'intensité sonore à long terme des données d'objet audio (132) est calculée sur de multiples échantillons des données d'objet audio, dans lequel l'intensité sonore à long terme des données de description audio (136) est calculée sur de multiples échantillons des données de description audio,
dans lequel chacune de la pluralité d'intensités sonores à court terme des données d'objet audio (132) est calculée sur un échantillon unique des données d'objet audio, et dans lequel chacune de la pluralité d'intensités sonores à court terme des données de description audio (136) est calculée sur un échantillon unique des données de description audio.

3. Procédé selon l'une quelconque des revendications 1-2, dans lequel la première pluralité de paramètres de mixage est associée à l'un d'une pluralité de genres, dans lequel chacun de la pluralité de genres est associé à un ensemble correspondant de paramètres de mixage.

4. Procédé selon l'une quelconque des revendications 1-3, dans lequel la première pluralité de paramètres de mixage inclut un paramètre d'anticipation, un paramètre de rampe et un paramètre delta maximum.

5. Procédé selon la revendication 4, dans lequel le paramètre d'anticipation correspond au maintien d'un ajustement de gain uniforme pendant une pause audio dans les données de description audio (136).

6. Procédé selon l'une quelconque des revendications 4-5, dans lequel le paramètre de rampe correspond à une période de temps pendant laquelle un ajustement de gain est appliqué graduellement.

7. Procédé selon l'une quelconque des revendications 4-6, dans lequel le paramètre delta maximum correspond à une différence d'intensité sonore maximale entre une trame des données d'objet audio (132) et une trame correspondante des données de description audio (136).

8. Procédé selon l'une quelconque des revendications 1-7, comprenant en outre les étapes consistant à :
recevoir une entrée d'utilisateur pour ajuster la seconde pluralité de paramètres de mixage, avant de générer les données d'objet audio mixées ; et
générer une visualisation d'ajustement de gain révisée correspondant à la seconde pluralité de paramètres de mixage ayant été ajustés en fonction de l'entrée d'utilisateur,
dans lequel les données d'objet audio mixées sont générées sur la base de la seconde pluralité de paramètres de mixage ayant été ajustés.

9. Procédé selon l'une quelconque des revendications 1-8, comprenant en outre les étapes consistant à :
avant de recevoir les données d'objet audio (132) :
recevoir des données audio (510), dans lequel les données audio n'incluent pas d'objet audio ; et
convertir les données audio en les données d'objet audio, et
après avoir généré les données d'objet audio mixées :
convertir les données d'objet audio mixées en données audio mixées, dans lequel les données audio mixées correspondent aux données audio mixées avec les données de description audio.

10. Support non transitoire lisible par ordinateur (615) stockant un programme informatique qui, lorsqu'il est exécuté par un processeur (601), commande un appareil (600) pour exécuter un traitement incluant le procédé selon l'une quelconque des revendications 1-9.

11. Appareil (600) de traitement audio, l'appareil comprenant :
un processeur (601),
dans lequel le processeur est configuré pour commander l'appareil afin de recevoir des données d'objet audio et des données de description audio, dans lequel les données d'objet audio incluent une première pluralité d'objets audio,
dans lequel le processeur est configuré pour commander l'appareil afin de calculer une intensité sonore à long terme des données d'objet audio et une intensité sonore à long terme des données de description audio,
dans lequel le processeur est configuré pour commander l'appareil afin de calculer une pluralité d'intensités sonores à court terme des données d'objet audio et une pluralité d'intensités sonores à court terme des données de description audio,
dans lequel le processeur est configuré pour commander l'appareil pour lire une première pluralité de paramètres de mixage qui correspondent aux données d'objet audio,
dans lequel le processeur est configuré pour commander l'appareil pour générer une seconde pluralité de paramètres de mixage sur la base de la première pluralité de paramètres de mixage, de l'intensité sonore à long terme des données d'objet audio, de l'intensité sonore à long terme des données de description audio, de la pluralité d'intensités sonores à court terme des données d'objet audio, et de la pluralité d'intensités sonores à court terme des données de description audio,
dans lequel le processeur est configuré pour commander l'appareil afin de générer une visualisation d'ajustement de gain correspondant à la seconde pluralité de paramètres de mixage, aux données d'objet audio et aux données de description audio, et
dans lequel le processeur est configuré pour commander l'appareil afin de générer des données d'objet audio mixées en mixant les données d'objet audio et les données de description audio conformément à la seconde pluralité de paramètres de mixage, dans lequel les données d'objet audio mixées incluent une seconde pluralité d'objets audio, dans lequel la seconde pluralité d'objets audio correspond à la première pluralité d'objets audio mixés aux données de description audio selon la seconde pluralité de paramètres de mixage.

12. Appareil (600) selon la revendication 11, comprenant en outre :
un affichage (602) qui est configuré pour afficher la visualisation d'ajustement de gain.

13. Appareil (600) selon l'une quelconque des revendications 11-12, dans lequel l'intensité sonore à long terme des données d'objet audio est calculée sur de multiples échantillons des données d'objet audio, dans lequel l'intensité sonore à long terme des données de description audio est calculée sur de multiples échantillons des données de description audio,
dans lequel chacune de la pluralité d'intensités sonores à court terme des données d'objet audio est calculée sur un échantillon unique des données d'objet audio, et dans lequel chacune de la pluralité d'intensités sonores à court terme des données de description audio est calculée sur un échantillon unique des données de description audio.

14. Appareil (600) selon l'une quelconque des revendications 11-13, dans lequel la première pluralité de paramètres de mixage est associée à l'un d'une pluralité de genres, dans lequel chacun de la pluralité de genres est associé à un ensemble correspondant de paramètres de mixage.

15. Appareil (600) selon l'une quelconque des revendications 11-14, dans lequel la première pluralité de paramètres de mixage inclut un paramètre d'anticipation, un paramètre de rampe et un paramètre delta maximum.
